# EUROPÄISCHE PATENTANMELDUNG

(11) **EP 0 771 028 A2**
(43) Veröffentlichungstag der Anmeldung: **02.05.1997**
(21) Anmeldenummer: 96202929.4
(22) Anmeldetag: 21.10.1996
(51) Int. Cl.: H01L 23/485

(54) **Halbleiterbauelement mit Passivierungsaufbau**

(30) Priorität: 28.10.1995 DE 19540309
(71) Anmelder: Philips Patentverwaltung GmbH, 22335 Hamburg (DE); PHILIPS ELECTRONICS N.V., 5621 BA Eindhoven (NL)
(72) Erfinder: Rabovsky, Johannes, Dipl.-Phys., 22335 Hamburg (DE); Sievers, Bernd, Dipl.-Phys., 22335 Hamburg (DE)
(74) Vertreter: Schmalz, Günther

(57) **Zusammenfassung**

Die Erfindung betrifft ein Halbleiterbauelement mit einem Substrat, mit mindestens einer Isolationsschicht mit mindestens einem Fenster, einem auf der Isolationsschicht aufliegenden Passivierungsaufbau und einer auf dem Passivierungsaufbau liegenden Metallisierung, wobei der Passivierungsaufbau aus mindestens zwei dielektrischen Schichten besteht und die erste dielektrische Schicht die Isolationsschicht mit deren Kanten sowie in einer äußeren Randzone des Fensters das Substrat bedeckt und die zweite dielektrische Schicht die erste dielektrische Schicht bis über die Kante der Isolationsschicht und in einem Teils des äußeren Bereichs des Fensters abdeckt.

Ein derartiges Halbleiterbauelement zeichnet sich durch verbesserte Spannungsfestigkeit, geringe Sperrströme und erhöhte Lebensdauerstabilität aus. Ein Vorteil des erfindungsgemäßen Planartransistors ist es, daß die elektrischen Parameter infolge des Schutzes der Übergänge zum Kontaktfenster und zu dem Bauteilrand durch den erfindungsgemäßen Passivierungsaufbau sehr stabil sind. Es werden Werte der Transitfrequenz f_{T} bis 300 MHz, Verlustleistungen bis 1 Watt und Spannungsfestigkeiten bis 1 kV erreicht. Trotz des gegenüber dem Stand der Technik verstärkten Passivierungsaufbaus ist die aktive Fläche des Transistors relativ groß durch die platzsparende Anordnung des erfindungsgemäßen Passivierungsaufbaus mit seinem strukturierten Randbereich. Ein weiterer Vorteil ist es, daß der Ausfall bei der Herstellung durch Bildung von Hohlkehlen sowohl an den Flanken der dielektrischen Schichten als auch an den Flanken der Isolationsschichten absolut vermieden wird. Ein Verfahren zur Herstellung des erfindungsgemäßen Halbleiterbauelementes ist ebenfalls angegeben.

## Beschreibung

Die Erfindung betrifft ein Halbleiterbauelement, insbesondere einen spannungsfesten, hochsperrenden bipolaren Planartransistor, mit einem Substrat, mindestens einer Isolationsschicht mit mindestens einem Fenster, mit einem auf der Isolationsschicht aufliegenden Passivierungsaufbau mit strukturiertem Randbereich und einer auf dem Passivierungsaufbau aufliegenden Metallisierung.

Spannungsfeste, hochsperrende bipolare Planartransistoren benötigt man für Schaltnetzteile, Motorsteuerungen, Gleichspannungswandler, Wechselrichter, Näherungsschalter, Breitbandverstärker, NF- Verstärker, Ultraschallgeneratoren, unterbrechungsfreie Stromversorgung, Überspannungsschutz, flimmerfreie Ansteuerung von Bildröhren, für Schaltungen von Leuchtstofflampen und in der Autoelektronik. Ein weiteres wichtiges Einsatzgebiet ist das Gebiet der geräuscharm geregelte Drehstromantriebe, weil die Forderung der Abschaltbarkeit und der höheren Betriebsfrequenz sich durch Thyristoren nicht erfüllen läßt. In dem betreffenden Spannungsbereich von 500 bis 1200 V ist das bipolare Transistorprinzip dem unipolaren MOS-Prinzip in der Stromdichte und damit in den Kosten überlegen.

Auch Phototransistoren gehören zu den spannungsfesten, hochsperrende Planartransistoren. Für sie sind Spannungsfestigkeiten bis zu einigen kV üblich.

Für solche spannungsfesten, hochsperrenden bipolare Planartransistoren ist es zur Erhöhung der Spannungsfestigkeit notwendig, daß durch geeignete Gestaltung der Randkonturen des Transistors eine Reduktion der Randfeldstärke erreicht wird. Insbesondere muß ein Passivierungsaufbau zwischen dem Substrat und der Metallisierung erzeugt werden, um die Durchbruchspannung des Transistors signifikant zu erhöhen und um einen vorzeitigen Durchbruch des Transistors u.a. bei Spannungs- oder Stromspitzen zu vermeiden. Dazu wird die Isolationsschicht aus thermisch oxidiertem SiO₂ und gegebenenfalls weiteren Isolationsschichten durch dielektrische Schichten zu einem Oberflächenpassivierungsaufbau verstärkt und dessen Randbereich zu den Kontaktfenstern und zum Transistorrand durch entsprechende Strukturierung abgeschrägt.

Bei der Strukturierung des Randbereiches durch Photolithographie und Schichtätzung nach dem Stand der Technik entstehen jedoch leicht Hohlkehlen an den Flanken des Oberflächenpassivierungsaufbaus infolge Unterätzung einzelner Schichten.

In diesen Unterätzungen können sich Verunreinigungen, insbesondere Feuchtigkeit und Ätzmittelreste ansammeln, die die Sperrströme des Halbleiterbauelementes erhöhen und die Lebensdauer des Bauelementes beeinträchtigen. Wenn anschließend die Metallisierungen in den Kontaktfenstern aufgebracht werden, dringt auch Metall in die Unterschneidungen ein. Dies mindert die Strom- und Spannungsfestigkeit. Bei stärkeren Unterätzungen können die unterätzten Kanten auch abbrechen.

Um diesem abzuhelfen, wird von der JP 2-37747 vorgeschlagen, auf einem Siliziumsubstrat eine erste isolierende Schicht kantengleich mit einer Zwischenschicht zu bedecken und diese beiden Schichten durch eine weitere Zwischenschicht und die weitere Zwischenschicht durch eine Passivierungsschicht vollständig abzudecken.

Dieses Verfahren erfordert zwei Photolithographie-Prozeßschritte mit anschließender Schichtätzung zur Bildung des Passivierungsaufbaus und ist damit umständlich und kostenintensiv. Außerdem hat der gebildete Planartransistor durch die platzraubenden Abdeckungen eine geringe aktive Fläche.

Es ist daher die Aufgabe der vorliegenden Erfindung, ein Halbleiterbauelement, insbesondere einen spannungsfesten, hochsperrenden bipolaren Planartransistor mit verbessertem Passivierungsaufbau mit strukturiertem Randbereich zur Verfügung zu stellen.

Erfindungsgemäß wird die Aufgabe gelöst durch ein Halbleiterbauelement mit einem Substrat, mindestens einer Isolationsschicht mit mindestens einem Fenster, einem auf der Isolationsschicht aufliegenden Passivierungsaufbau und einer auf dem Passivierungsaufbau liegenden Metallisierung, wobei der Passivierungsaufbau aus mindestens zwei dielektrischen Schichten besteht und die erste dielektrische Schicht die Isolationsschicht mit deren Kanten sowie in einer äußeren Randzone des Fensters das Substrat bedeckt und die zweite dielektrische Schicht die erste dielektrische Schicht bis über die Kante der Isolationsschicht und in einem Teil des äußeren Bereichs des Fensters abdeckt.

Ein derartiges Halbleiterbauelement zeichnet sich durch verbesserte Spannungsfestigkeit, geringe Sperrströme und erhöhte Lebensdauerstabilität aus. Ein Vorteil des erfindungsgemäßen Planartransistors ist es, daß die elektrischen Parameter infolge des Schutzes der Übergänge zum Kontaktfenster und zu dem Bauteilrand durch den erfindungsgemäßen Passivierungsaufbau sehr stabil sind. Es werden Werte der Transitfrequenz f_{T} bis 300 MHz, Verlustleistungen bis 1 Watt und Spannungsfestigkeiten bis 1 kV erreicht. Trotz des gegenüber dem Stand der Technik verstärkten Passivierungsaufbaus ist die aktive Fläche des Transistors relativ groß durch die platzsparende Anordnung des erfindungsgemäßen Passivierungsaufbaus mit seinem strukturiertem Randbereich. Ein weiterer Vorteil ist es, daß der Ausfall bei der Herstellung durch Bildung von Hohlkehlen sowohl an den Flanken der dielektrischen Schichten als auch an den Flanken der Isolationsschichten absolut vermieden wird.

Im Rahmen der vorliegenden Erfindung ist es bevorzugt, daß jede der dielektrischen Schichten eine gleichmäßige Schichtdicke hat. Dadurch ergibt sich zusammen mit den Überlappungen der Schichten des Passivierungsaufbaus eine Randabschrägung mit flachem Profil, die die Randfeldstärke verringert und die Spannungsfestigkeit erhöht. Die Randabschrägung mit flachem Profil verbessert auch im Bereich des Kontaktfensters die Haftung der Metallisierung auf dem Passivierungsaufbau sowie deren Zusammenhalt über die Kante des Fensters hinweg.

Im Rahmen der vorliegenden Erfindung ist es bevorzugt, daß das Halbleiterbauelement zwei Isolationsschichten aufweist, wobei die erste Isolationsschicht aus einem thermisch erzeugten Siliziumoxid und die zweite Isolationsschicht aus einem phosphorhaltigen thermisch erzeugten Siliziumoxid besteht. Das thermisch erzeugte phosphorhaltige Siliziumoxid haftet besonders gut auf dem Substrat sowie auf der Isolationsschicht aus thermisch erzeugtem Siliziumoxid. Es wirkt als Ionengetter und schützt dadurch den darunterliegenden Teil des Bauelementes vor möglichen Kontaminierungen, die ein großes Risiko für die Zuverlässigkeit des Halbleiterbauelementes darstellen.

Es ist weiterhin bevorzugt, daß die erste dielektrische Schicht aus Siliziumnitrid und die zweite dielektrische Schicht aus Siliziumdioxid besteht.

Im Rahmen der vorliegenden Erfindung kann es bevorzugt sein, daß erste dielektrische Schicht aus Siliziumoxid oder Siliziumnitrid und die zweite dielektrische Schicht aus Polyimid besteht.

Weiterhin kann es bevorzugt sein, daß die erste dielektrische Schicht aus Polyimid und die zweite dielektrische Schicht aus Siliziumnitrid besteht.

Diese dielektrischen Schichten haben jeweils eine hohe Selektivität gegenüber dem zur Strukturierung der jeweils anderen Schicht benötigten Ätzmedium, so daß beide Schichten in einem einzigen photolithographischen Schritt strukturiert werden können.

Ein anderer Aspekt der Erfindung betrifft ein Verfahren zur Herstellung eines Halbleiterbauelementes mit einem Substrat, mit mindestens einer Isolationsschicht mit mindestens einem Fenster, einem auf der Isolationsschicht aufliegenden Passivierungsaufbau und einer auf dem Passivierungsaufbau liegenden Metallisierung, wobei der Passivierungsaufbau aus mindestens zwei dielektrischen Schichten besteht, wobei auf dem Substrat mit mindestens einer Isolationsschicht mit mindestens einem Fenster ganzflächig eine erste und eine zweite dielektrische Schicht aufgebracht werden, in die ein oder mehrere kleinere Fenster geätzt werden, so daß eine äußere Randzone des ursprünglichen Fensters mit der ersten und der zweiten dielektrischen Schicht bedeckt bleibt und anschließend die zweite dielektrische Schicht nochmals geätzt wird, so daß die zweite dielektrische Schicht die erste dielektrische Schicht im Bereich der äußeren Randzone des Fensters teilweise bedeckt.

Durch dieses Verfahren wird ein Halbleiterbauelement mit einem Passivierungsaufbau mit strukturiertem Randbereich mit flachem Randprofil erhalten. Die Isolationsschicht kann durch die Abdeckung durch die erste dielektrische Schicht nicht unterätzt werden. Eine eventuelle Unterätzung der ersten dielektrischen Schicht wird durch das Zurücksetzen der Kante der zweiten dielektrischen Schicht im letzten Ätzprozeß aufgehoben.

Es ist bevorzugt, daß die Ätzung des (der) Fenster(s) durch ein photolithographisches Verfahren erfolgt und die erste und zweite dielektrische Schicht mit einer Photolackmaske und zwei selektiven Ätzmedien geätzt werden, wobei zunächst die zweite dielektrische Schicht mit der Photolackmaske und einem Ätzmedium, das selektiv zur ersten dielektrischen Schicht ist, strukturiert wird, dann die Photolackmaske entfernt wird und die erste dielektrische Schicht mit einem zu zweiten dielektrischen Schicht selektiven Ätzmedium strukturiert wird, wobei die zweite dielektrische Schicht als Maske dient und dann die zweite dielektrische Schicht nochmals mit einem selektiven Ätzmedium soweit geätzt wird, daß die erste dielektrische Schicht im Bereich der äußeren Randzone des Fensters teilweise freigelegt wird.

Durch dieses Verfahren wird ein photolithographischer Strukturierungsschritt eingespart. Neben der Kostenersparung resultiert daraus eine deutliche Verbesserung der Prozeßsicherheit und der Produktqualität, da Unterätzungen im Passivierungsaufbau und in den Isolationsschichten vermieden werden.

Nachfolgend wird die Erfindung anhand einer Zeichnung weiter erläutert.

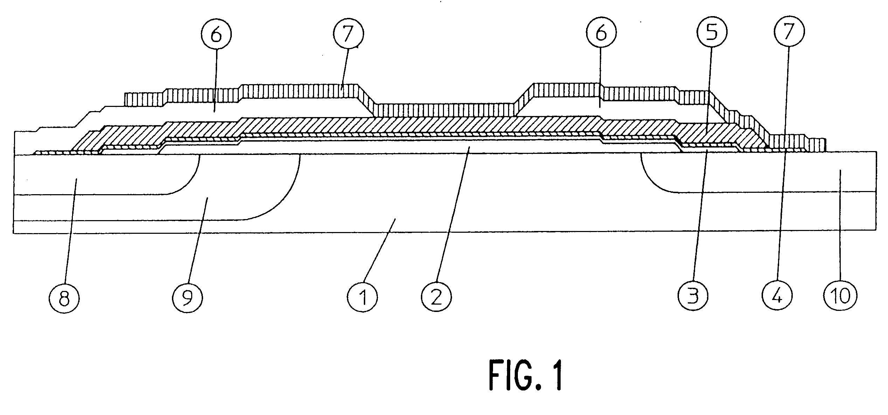

Fig. 1 zeigt einen Querschnitt des erfindungsgemäßen Planartransistors.

Der erfindungsgemäße Planartransistor baut sich auf einem Substrat 1 auf, das üblicherweise aus 0,2 mm dünnen entweder n- oder p- leitenden Siliziumeinkristallen von 0,1-10 mm² Oberfläche besteht. Das Substrat enthält pn-Übergänge, die durch Diffusion eingebaut werden. Diese pn Übergänge begrenzen beispielsweise den Übergang vom Basisdiffusionsgebiet 9 zum Emitterdiffusionsgebiet 8. Der hochdotierte Kanalstopper 10 wird zusammen mit dem Emitterdiffusionsgebiet hergestellt und besitzt die gleiche Leitfähigkeitsart wie das Substrat. Der hochdotierte Kanalstopper 10, der den äußeren Rand des diskreten Bauelements markiert, verhindert das Fließen von Leckströmen von der Basis über einen Kanal unter der Isolationsschicht 2 über die Transistorsägebahn zum rückseitigen Kollektor.

Die erste Isolationsschicht 2 besteht im allgmeinen aus einer undurchlässigen Schicht aus thermisch erzeugtem Siliziumdioxid. Die Kanten der Isolationsschicht(en) begrenzen ein oder mehrere Fenster. Im Bereich dieser ursprünglichen Fenster liegt die Substratoberfläche zunächst offen.

Die erste Isolationsschicht 2 kann vollständig mit einer zweiten Isolationsschicht 3 bedeckt sein. Diese zweite Isolationsschicht erstreckt sich über die Kante der ersten Isolationsschicht und bedeckt in einer äußeren Randzone des ursprünglichen Fensters das Substrat. In diesem Fall definieren die Kanten der zweiten Isolationsschicht das bzw. die Fenster. Die zweite Isolationsschicht hat üblicherweise eine Schichtdicke von 0,1 bis 0,4 µm, sie bedeckt das Substrat in einer Breite von mindestens 1 µm.

Die Isolationsschichten sind vollständig von einer ersten dielektrischen Schicht 4 bedeckt. Diese erste dielektrische Schicht erstreckt sich über die Kante der obersten Isolationsschicht und bedeckt in einer äußeren Randzone des ursprünglichen Fensters das Substrat. Die erste dielektrische Schicht hat üblicherweise eine Schichtdicke von 0,1 bis 0,2 µm, die äußere Randzone eine Breite von mindestens 1 µm. Die zweite dielektrische Schicht 5 erstreckt sich über die erste dielektrische Schicht einschließlich der äußersten Kante der Isolatonsschichten. Die Kante der zweiten dielektrischen Schicht ist gegenüber der Kante der ersten dielektrischen Schicht mindestens 0,1 µm zurückgesetzt. Die Schichtdicke der zweiten dielektrischen Schicht beträgt üblicherweise 0,1 bis 1,6 µm.

Die Randabschrägung hat im allgemeinen einen Flankenwinkel von 30° bis 60° gegenüber der Substratoberfläche.

Die Metallisierung 6 bedeckt als Planar-Kontakt das Fenster, den strukturierten Randbereich des Passivierungsaufbaus und einen Teil der zweiten dielektrischen Schicht.

Die Metallisierung kann aber auch als Elektrode nur auf der zweiten dielektrischen Schicht aufgebracht sein und in mindestens einer Ecke des Halbleiterbauelementes einen ohmschen Kontakt zum Substrat haben.

Um das Halbleiterbauelement vor mechanischen und chemischen Angriff zu schützen, kann das Halbleiterbauelement weiterhin mit einer schützenden Deckschicht 7 abgedeckt sein.

Das erfindungsgemäße Bauelement kann als diskretes Halbleiterbauelement oder Bestandteil einer integrierten Schaltung in Planartechnik hergestellt werden. Fertigungstechnisch geht man von einer weit größeren als für die Herstellung eines einzelnen Transistors oder einer bestimmten Schaltung notwendigen Siliziumscheibe aus und benutzt für die Formierung der abdeckenden Oxidstrukturen, die ein Eindiffundieren der Dotierungsstoffe an nicht gewünschten Stellen verhindern, ein schachbrettartiges Muster mit einem Rasterabstand von etwa 0,3 bis 3,5 mm. Bei der Verarbeitung einer Siliziumscheibe (Wafer) entstehen so gleichzeitig bis zu 80 000 diskrete Transistoren oder 50 bis 100 Festkörperschaltkreise. Erst nach dem Aufbringen und Strukturieren aller Schichten und dem Aufbringen der Kontakte und Leiterbahnen wird die Siliziumscheibe in die einzelnen Halbleiterbauelemente, geteilt, die anschließend kontaktiert und gefaßt werden.

Zur Herstellung des erfindungsgemäßen Passivierungsaufbaus geht man von einem vorbereiten Wafer aus, in dem die Basis- und Emitterdiffusionsgebiete bereits eingebracht worden sind und der ein oder mehrere, üblicherweise zwei Isolationsschichten aufweist. Die erste Isolationsschicht aus thermisch erzeugten Siliziumdioxid wird in bekannter Art und Weise aufgebracht und mit Fenstern versehen. Die zweite Isolationsschicht aus phosphorhaltigem thermischen Siliziumoxid wird während des Emitterprozesses bei NPN-Transistoren bzw. während des Basiskontaktdiffusionsprozesses bei PNP-Transistoren gebildet.

Im folgenden Photolithographie- und Ätzschritt werden mit einer Maske kleine Kontaktfenster für Basis und Emitter in beide Isolationsschichten geätzt. Beide Isolationsschichten werden mit dem gleichen Ätzmedium, gepufferter Flußsäure, strukturiert.

Auf diesen Unterbau werden die dielektrische Schichten für den Passivierungsaufbau durch Abscheidung aus der Gasphase aufgebracht. Üblicherweise wird der Passivierungsaufbau aus zwei dielektrischen Schichten gebildet. Die auf der obersten Isolationsschicht aufliegende erste dielektrische Schicht ist üblicherweise eine Siliziumnitridschicht, die in einem Low - Pressure - CVD - Verfahren hergestellt wird, beispielsweise bei 300 - 400 Millitorr bei 700 bis 800 °C aus SiH₂Cl₂ und NH₃. Die zweite dielektrische Schicht ist üblicherweise eine Siliziumdioxidschicht, die durch ein Plasma-Enhanced-Verfahren mit einer Plasmaanregung von beispielsweise 380 kHz und 15 kW bei 300 bis 350 °C aus SiH₄ und N₂O erzeugt wird. Beide Schichten werden zunächst ganzflächig abgeschieden. Beide Schichten werden gemeinsam strukturiert.

Dazu wird eine Photolackmaske aufgebracht, belichtet und entwickelt. Dann wird zunächst die Siliziumdioxidschicht mit einem Flußsäure/Ammoniumfluorid-Gemisch isotrop geätzt. In diesem Verfahrensschritt wird die Siliziumnitridschicht nicht angegriffen, weil das Flußsäure/Ammoniumfluorid-Gemisch eine hohe Selektivität gegenüber Siliziumnitrid besitzt. Dann wird die Photolackmaske entfernt. Daraufhin wird die Siliziumnitridschicht mit heißer Phosphorsäure isotrop und feucht geätzt, wobei die vorgeätzte SiO₂-Schicht als Maske fungiert. In diesem Verfahrensschritt wird die SiO₂-Schicht nicht angegriffen, weil auch die heiße Phosphorsäure eine hohe Selektivität besitzt. Um die Kante der Siliziumdioxidschicht hinter die Kante des Siliziumnitrids zurückzusetzen, wird anschließend noch einmal mit dem Flußsäure/ Ammoniumfluorid-Gemisch geätzt.

Die Siliziumnitridschicht kann auch durch ein Plasma-Enhanced-Verfahren abgeschieden werden. In diesen Fall sollte die zweite dielektrische Schicht aus Polyimid bestehen. Für die Abscheidung des Siliziumoxids stehen eine Reihe von Verfahren zur Verfügung, z.B. die Abscheidung aus Tetraethylorthosilikat in einem Heißwandreaktor, die Abscheidung aus Silan und Sauerstoff in einem CVD-Verfahren bei niedrigen Temperaturen, die Abscheidung aus Silan und einer Stickstoffsauerstoffverbindung bei höheren Temperaturen oder die Abscheidung in einem Spin-on Verfahren aus entsprechenden Ausgangsverbindungen (Spin-On-Glass)

Man kann auch andere Materialkombinationen für den Schichtaufbau wählen. Es müssen jedoch eine Reihe von Verträglichkeitsbedingungen erfüllt sein, insbesondere hinsichtlich Diffusion, Haftung, selektiver Ätzbarkeit wie oben beschrieben, mechanischer und thermischer Spannungen. Als geeignet haben sich die folgenden Kombinationen für die erste und zweite dielektrische Schicht erwiesen:
- Siliziumdioxid in Form von Plasma-Oxid, LTO ("low temperature oxide"), TEOS (Tetraethylorthosilikat als Ausgangsverbindung) oder LPCVD-Oxid als erste Schicht, Ätzmittel Flußsäure/Ammoniumfluorid, und Polyimid als zweite Schicht, Ätzmittel Hydrazin,
- Polyimid als erste Schicht, Ätzmittel Hydrazin, und Siliziumnitrid in Form von Plasma-Nitrid als zweite Schicht, Ätzmittel heiße Phosphorsäure,
- Siliziumnitrid in Form von Plasma-Nitrid oder LPCVD-Nitrid, Ätzmittel heiße Phosphorsäure, als erste Schicht und Polyimid, Ätzmittel Hydrazin, als zweite Schicht, oder
- Siliziumnitrid in Form von LPCVD-Nitrid, Ätzmittel heiße Phosphorsäure, als erste Schicht und Siliziumdioxid in Form von LTO oder TEOS oder Spin-on-Glas (SOG), Ätzmittel Flußsäure/Ammoniumfluorid, als zweite Schicht.

In einem weiteren Verfahrensschritt wird die Metallisierung aufgebracht, im allgemeinen durch Aufdampfen von hochreinem Aluminium.

Schließlich wird die Metallisierung im allgemeinen noch durch eine Schutzschicht vor mechanischem Angriff, Korrosion und Ionenkontaminierung geschützt. Dazu wird das Bauteil mit einer Schicht aus Siliziumnitrid, SiO₂, Phosphorsilikatglas oder Polyimid abgedeckt.

Durch den verbesserten Passivierungsaufbau erreichen planare bipolare NPN- und PNP-Hochspannungstransistoren eine Spannungsfestigkeit von 500 V bis 1000 V und planare NPN- und PNP-Darlington-Transistoren eine Spannungsfestigkeit von bis zu 200 V.
Die Halbleiterbauelemente wurden einem beschleunigten Lebensdauertest (ALT) durch Auslagerung bei 150 °C unterworfen. Sie erreichten eine Lebensdauer von mehr als 1000 h und die Ausschußquote reduzierte sich drastisch. Durch das erfindungsgemäße Verfahren wird ein photolithographischer Strukturierungschritt eingespart. Neben der Kostenersparung resultiert daraus eine deutliche Verbesserung der Prozeßsicherheit und der Produktqualität, da Unterätzungen im Passivierungsaufbau und in den Isolationsschichten vermieden werden.

## Patentansprüche

1. Halbleiterbauelement mit einem Substrat, mindestens einer Isolationsschicht mit mindestens einem Fenster, einem auf der Isolationsschicht aufliegendem Passivierungsaufbau und einer auf dem Passivierungsaufbau liegender Metallisierung, wobei der Passivierungsaufbau aus mindestens zwei dielektrischen Schichten besteht und die erste dielektrische Schicht die Isolationsschicht mit deren Kanten sowie in einer äußeren Randzone des Fensters das Substrat bedeckt und die zweite dielektrische Schicht die erste dielektrische Schicht bis über die Kante der Isolationsschicht und in einem Teils des äußeren Bereichs des Fensters abdeckt.

2. Halbleiterbauelement nach Anspruch 1,
dadurch gekennzeichnet,
daß jede der dielektrischen Schichten eine gleichmäßige Schichtdicke hat.

3. Halbleiterbauelement nach Anspruch 2,
dadurch gekennzeichnet,
daß es zwei Isolationsschichten aufweist, wobei die erste Isolationsschicht aus einem thermisch erzeugten Siliziumoxid und die zweite Isolationsschicht aus einem phosphorhaltigem thermisch erzeugten Siliziumoxid besteht.

4. Halbleiterbauelement nach Anspruch 3,
dadurch gekennzeichnet,
daß die erste dielektrische Schicht aus Siliziumnitrid und die zweite dielektrische Schicht aus Siliziumdioxid besteht.

5. Halbleiterbauelement nach Anspruch 3,
dadurch gekennzeichnet,
daß erste dielektrische Schicht aus Siliziumoxid oder Siliziumnitrid und die zweite dielektrische Schicht aus Polyimid besteht.

6. Halbleiterbauelement nach Anspruch 3,
dadurch gekennzeichnet,
daß die erste dielektrische Schicht aus Polyimid und die zweite dielektrische Schicht aus Siliziumnitrid besteht.

7. Verfahren zur Herstellung eines Halbleiterbauelementes mit einem Substrat, mit mindestens einer Isolationsschicht mit mindestens einem Fenster, einem auf der Isolationsschicht aufliegendem Passivierungsaufbau und einer auf dem Passivierungsaufbau liegenden Metallisierung, wobei der Passivierungsaufbau aus mindestens zwei dielektrischen Schichten besteht, wobei auf dem Substrat mit mindestens einer Isolationsschicht mit mindestens einem Fenster ganzflächig eine erste und eine zweite dielektrische Schicht aufgebracht werden, in die ein oder mehrere kleinere Fenster geätzt werden, so daß eine äußere Randzone des ursprünglichen Fensters mit der ersten und der zweiten dielektrischen Schicht bedeckt bleibt und anschließend die zweite dielektrische Schicht geätzt wird, so daß die zweite dielektrische Schicht die erste dielektrische Schicht im Bereich der äußeren Randzone des Fensters teilweise bedeckt.

8. Verfahren nach Anspruch 7,
dadurch gekennzeichnet,
daß die Ätzung des (der) Fenster(s) durch ein photolithographisches Verfahren erfolgt und die erste und zweite dielektrische Schicht mit einer Photolackmaske und zwei selektiven Ätzmedien geätzt werden, wobei zunächst die zweite dielektrische Schicht mit der Photolackmaske und einem Ätzmedium, das selektiv zur ersten dielektrischen Schicht ist, strukturiert wird, dann die Photolackmaske entfernt wird und die erste dielektrische Schicht mit einem zu zweiten dielektrischen Schicht selektiven Ätzmedium strukturiert wird, wobei die zweite dielelektrische Schicht als Maske dient und dann die zweite dielektrische Schicht nochmals mit einem selektiven Ätzmedium soweit geätzt wird, daß die erste dielektische Schicht im Bereich der äußeren Randzone des Fensters teilweise freigelegt wird.
